# FASCICULE DE BREVET EUROPEEN

(11) **EP 0 385 836 B1**
(45) Date de publication et mention de la délivrance du brevet: **10.12.1997**
(21) Numéro de dépôt: 90400513.9
(22) Date de dépôt: 23.02.1990
(51) Int. Cl.: G06F 11/20

(54) **Procédé pour remplacer des modules mémoire dans un système informatique et système informatique pour la mise en oeuvre du procédé**
Verfahren zum Ersetzen von Speichermodulen in einem Computersystem und Computersystem zur Durchführung des Verfahrens
Method for replacing memory modules in a computer system and computer system for carrying out this method

(30) Priorité: 03.03.1989 FR 8902751
(43) Date de publication de la demande: 05.09.1990
(73) Titulaire: BULL S.A., 92800 Puteaux (FR)
(72) Inventeur: Bacot, Pierre, F-75016 Paris (FR); Magnaud, Guy, F-75016 Paris (FR); Pairault, Jean-Jacques, F-75016 Paris (FR)
(74) Mandataire: Colombe, Michel

(56) Documents cités:
- EP-A- 0 076 629
- EP-A- 0 078 942
- EP-A- 0 141 245
- FR-A- 2 273 320
- FR-A- 2 291 544
- ELECTRONICS. vol. 56, no. 2, 27 janvier 1983, NEW YORK US pages 103 - 105; GARDNER HENDRIE: "A hardware solution to part failures totally insulates programs"

## Description

L'invention se situe dans le domaine des systèmes informatiques et concerne plus particulièrement les problèmes relatifs à l'amélioration de la disponibilité de ces systèmes.

Depuis longtemps, les concepteurs se sont attachés à améliorer la fiabilité des systèmes. Des progrès importants ont été obtenus grâce notamment à la meilleure fiabilité des composants. D'autre part, une organisation logique et technologique du système appropriée permet d'éviter des erreurs malgré la présence de défauts dans ces composants.

Cependant, quelle que soit l'importance des moyens employés, les possibilités de masquer des défauts en corrigeant des erreurs ne sont pas illimitées. Cette limitation devient particulièrement sensible lorsque la complexité du système augmente.

Pour remédier à cette difficulté, on est conduit à prévoir la possibilité de remplacer les éléments défectueux du système.

Bien entendu, les perturbations provoquées par une telle réparation doivent être aussi réduites que possible car elles influent sur la disponibilité du système.

Pour aborder le problème de la disponibilité, il faut considérer les différents éléments qui constituent un système informatique. Un système comprend essentiellement un certain nombre d'unités de trois types : les processeurs, les modules mémoire et les contrôleurs d'entrée-sortie. On prévoit généralement plusieurs processeurs qui communiquent, par l'intermédiaire d'un bus, avec plusieurs modules mémoire. Les processeurs peuvent être branchés directement sur le bus ou par l'intermédiaire d'un contrôleur servant d'interface. Pour pouvoir communiquer avec l'extérieur, les processeurs sont également reliés à une ou plusieurs unités d'entrée-sortie. A côté de ces éléments essentiels, on leur associe généralement un dispositif de maintenance habituellement appelé "processeur de service", utilisé pour l'initialisation du système et pour la maintenance, par exemple pour la prise en compte des erreurs détectées dans les diverses unités.

Dans un système à plusieurs processeurs élémentaires (système multiprocesseur), la défaillance de l'un des processeurs ne provoque pas forcément l'interruption immédiate du système. En effet, si des erreurs persistantes dans un processeur sont détectées par le processeur de service, ce dernier peut déconnecter logiquement le processeur défaillant. Il en résulte que le système peut continuer à fonctionner grâce aux processeurs restants avec, bien sûr, une dégradation des performances. Le service de maintenance devra ultérieurement remplacer le processeur défaillant par un processeur de remplacement et commander sa reconnexion logique. Ces opérations peuvent être réalisées grâce aux possibilités de reconfiguration dont sont munis habituellement les systèmes actuels.

Dans un système bien conçu, la défaillance d'un processeur et son remplacement n'entraîne pas d'importantes perturbations visibles de l'utilisateur. En effet, grâce à la redondance, le fonctionnement n'est pas interrompu et le processus en cours d'exécution dans le processeur défaillant au moment de la panne peut être réexécuté. La défaillance d'un module mémoire pose par contre un problème tout différent car le module défectueux peut contenir des données impossibles à reconstituer. Ceci peut être d'autant plus grave que ces données concernent le système lui-même. Même si le système d'exploitation est conçu pour effectuer périodiquement des sauvegardes du contenu de la mémoire dans des mémoires extérieures, un module contenant des données dernièrement mises à jour peut tomber en panne avant qu'une telle sauvegarde ait pu être exécutée.

Pour réduire ce risque, les modules mémoire actuels sont constitués d'une pluralité de composants de façon à ce que chacun des bits constituant un mot technologique soit stocké dans un composant différent. Il en résulte que les probabilités de pannes sur deux bits quelconques d'un mot sont égales et indépendantes, ce qui permet d'utiliser un code autocorrecteur du type Hamming mémorisé dans des composants supplémentaires. Ainsi, la défaillance d'un ou de plusieurs composants peut être détectée et corrigée.

Cependant, au cours de la vie du module, les défaillances peuvent s'accumuler jusqu'à ce qu'il ne soit plus possible de les corriger. Il convient donc d'effectuer un remplacement de module avant d'atteindre cette limite. Toutefois, il faut tenir compte du fait que des données utiles peuvent être mémorisees dans ce module. Dans la mesure où le système d'exploitation le permet, une solution peut consister à recopier le contenu du module défaillant dans une mémoire extérieure. C'est par exemple le cas exposé dans la demande de brevet FR-A-2291544 où, dans un mode de réalisation préférée, cette mémoire extérieure est une bande de mémorisation de maintiens auxiliaires. Un module à faible probabillité d'utilisation permet d'être réservé comme module de remplacement. Suite à la défaillance d'un module, le service du système est interrompu pour recharger les informations sauvegardées de la mémoire extérieure vers le module de remplacement . Ceci risque de perturber le fonctionnement du système. L'accès au module en défaut est inhibé et le module de remplacement se substitue au module en défaut. Cette solution est cependant difficile à mettre en oeuvre, en particulier dans le cas où le module défaillant contient des éléments du système d'exploitation.

Une autre solution peut consister à transférer les données du module en panne dans un ou plusieurs autres modules du système. Cependant, cette méthode nécessite une réallocation de l'espace mémoire qui entraîne une complication du logiciel qui devra gérer des tables de correspondance d'adresses pour l'espace mémoire impliqué.

Aussi l'invention a pour but de proposer une solution simple pour remplacer des modules mémoire tout en perturbant le moins possible le fonctionnement du système. Plus précisément l'invention a pour objet un procédé pour effectuer le remplacement d'un ou de plusieurs modules mémoire d'un système informatique, lesdits modules communiquant avec des moyens de traitement dudit système par l'intermédiaire d'un bus, ledit bus étant muni d'emplacements de connexion sur lesquels sont branchés lesdits modules, ledit procédé étant caractérisé en ce qu'il consiste :
a) à prévoir, outre les emplacements de connexion nécessaires au système dans sa configuration normale, au moins un emplacement de connexion supplémentaire,
b) lorsqu'un module à remplacer est identifié, à connecter un module de remplacement sur un desdits emplacements de connexion supplémentaires,
c) pour toute demande d'écriture adressée audit module à remplacer, à faire exécuter ladite demande d'écriture simultanément et à la même adresse par ledit module à remplacer et par son module de remplacement et, pour toute demande de lecture adressée audit module à remplacer, à n'autoriser que ledit module à remplacer à exécuter ladite demande de lecture,
d) à lancer un processus de recopie composé de demandes de lecture puis de réécriture à un ensemble d'adresses recouvrant la totalité de l'espace mémoire du module à remplacer,
e) une fois ledit processus de recopie terminé, pour toute demande ultérieure adressée audit module à remplacer, à n'autoriser que ledit module de remplacement à exécuter, à la même adresse, ladite demande ultérieure.

Il est important de noter que ce procédé permet que le processus de recopie s'exécute en concurrence avec d'autres programmes en cours d'exécution dans le système. En effet, pendant toute la période de recopie, toutes les demandes adressées au module à remplacer peuvent être satisfaites sans qu'il soit besoin d'attendre la fin de la recopie. Par contre, avec les méthodes classiques effectuant une reconfiguration mémoire généralement manuelle, les programmes situés dans le module en cause devront être repris.

Ainsi, pour mettre à profit cette possibilité et selon une caractéristique supplémentaire de l'invention, le processus de recopie est exécutable en parallèle avec d'autres programmes en cours d'exécution dans le système.

L'exécution du processus de recopie impose que toute demande de lecture destinée au module à remplacer ne soit exécutée que dans ce module à remplacer et non pas dans le module de remplacement. Pour cela, on pourrait prévoir que les demandes de lecture seront envoyées uniquement au module à remplacer. Bien que cette solution soit envisageable, elle présente des difficultés de mise en oeuvre dans le cas suivant : lorsque le processus de recopie est terminé, le module de remplacement changera de statut pour devenir un module "titulaire". Or, à partir de l'instant où ce changement de statut survient, les opérations de lecture et d'écriture adressées au module à remplacer doivent être exécutées normalement par le module de remplacement. Simultanément, plus aucune autre demande ne doit être exécutée par le module à remplacer. Or l'exécution d'une demande de lecture nécessite en général plusieurs phases opératoires. Par conséquent, avec la méthode envisagée, il faut éviter que le changement de statut se produise pendant une opération de lecture. Pour cela, on pourrait prévoir un mécanisme pour n'autoriser les changements de statut qu'en dehors des périodes de lecture, mais il en résulterait une complication de la mise en oeuvre.

Pour remédier à cet inconvénient et selon un autre aspect particulier de l'invention, pendant tout le processus de recopie, toute demande de lecture ou d'écriture est envoyée à la fois au module à remplacer et au module de remplacement et dans le cas d'une demande de lecture, les deux modules accèdent normalement aux données à lire mais l'envoi par le module de remplacement des données accédées est inhibé.

Ainsi, même si un changement de statut survient pendant une opération de lecture, cette opération sera effectuée correctement.

Selon une autre caractéristique de l'invention, l'inhibition de l'envoi des données accédées est conditionnée par la présence d'un indicateur de mode permettant de marquer le module de remplacement, signalant ainsi son statut de remplaçant.

Dans les systèmes classiques comportant plusieurs modules mémoire, une opération de lecture ou d'écriture est habituellement initialisée par l'envoi au module concerné d'un signal de sélection engendré à partir d'une adresse. Ces systèmes sont donc munis d'un circuit de sélection qui, en fonction de l'adresse logique fournie par l'un des processeurs, délivre un signal de sélection parmi n, n étant le nombre de modules. Pour la mise en oeuvre de l'invention, il faut modifier le circuit de sélection, mais avantageusement, de façon aussi simple que possible. Pour cela, on réutilise le circuit classique, mais ses signaux ne sont plus transmis directement aux modules. Ils servent de signaux intermédiaires, appelés "signaux de sélection logique" permettant de définir des modules "logiques" visibles au niveau logiciel. On effectue ensuite une correspondance module logique - module physique au niveau matériel par une conversion des signaux logiques en signaux physiques. En fonctionnement normal, cette correspondance sera biunivoque. Par contre, pendant une recopie, à ùn signal logique correspondra deux signaux physiques transmis à la fois au module à remplacer et au module de remplacement.

Plus précisément et selon un autre aspect de l'invention, le procédé est caractérisé en ce que, le système comportant n modules dans sa configuration normale, toute demande active, en fonction de l'adresse associée, un signal parmi n, appelé "signal de sélection logique" et en ce que, chaque module effectivement connecté au bus pouvant être commandé par un signal de sélection appelé "signal de sélection physique", pour pouvoir sélectionner simultanément deux modules en réponse à une demande déterminée, ledit signal de sélection logique associé à ladite demande déterminée active simultanément deux signaux de sélection physique appliqués respectivement auxdits deux modules.

L'invention a également pour objet un système informatique permettant la mise en oeuvre du procédé exposé précédemment. Le système selon l'invention comprend des moyens de traitement reliés à plusieurs modules mémoire par l'intermédiaire d'un bus, ledit bus étant muni d'emplacements de connexion sur lesquels sont branchés lesdits modules. Le système comprend aussi des moyens de commande pour sélectionner lesdits modules en réponse aux adresses associées aux demandes d'accès mémoire issues desdits moyens de traitement et un dispositif de maintenance est en outre relié audit système. Le système est en outre caractérisé en ce que :
a) outre les emplacements de connexion nécessaires au système dans sa configuration normale, au moins un emplacement de connexion supplémentaire est prévu pour y recevoir des modules de remplacement,
b) pour pouvoir effectuer le remplacement d'un module par un autre, lesdits moyens de commande peuvent être positionnés par le dispositif de maintenance de façon à ce que :
   - toute demande d'écriture adressée à un module à remplacer est exécutée à la fois et à la même adresse par ledit module à remplacer et un module de remplacement associé et
   - toute demande de lecture adressée audit module à remplacer n'est exécutée que par ledit module à remplacer,
c) ledit système comprend des moyens pour exécuter, sous la commande dudit dispositif de maintenance un processus de recopie composé de demandes de lecture puis de réécriture à un ensemble d'adresses recouvrant la totalité de l'espace mémoire du module à remplacer.

Selon un mode de réalisation particulier, le système est caractérisé en ce que lesdits moyens pour exécuter ledit processus de recopie consiste en un programme ou un microprogramme chargé dans lesdits moyens de traitement et en ce que ledit programme ou microprogramme est exécutable en parallèle avec d'autres programmes en cours d'exécution dans lesdits moyens de traitement.

D'autres caractéristiques et détails de réalisation pour la mise en oeuvre de l'invention seront exposés dans la suite de la description en relation avec les figures où :
- la figure 1 représente de façon schématique un système informatique pour la mise en oeuvre de l'invention ;
- la figure 2 représente l'organisation d'un contrôleur mémoire du système selon l'invention ;
- la figure 3 représente des moyens du contrôleur mémoire pour engendrer les signaux de sélection logique ;
- la figure 4 représente un circuit de conversion logique - physique de signaux émis par le contrôleur mémoire ;
- la figure 5 représente un détail de réalisation du circuit de conversion de la figure 4 ;
- la figure 6 représente un circuit de conversion physique - logique de signaux reçus par le contrôleur mémoire ;
- la figure 7 représente un module mémoire et les principaux signaux qu'il échange avec le bus ;
- la figure 8 représente un circuit d'inhibition de lecture d'un module mémoire ;
- la figure 9 représente un autre mode de réalisation du circuit d'inhibition.

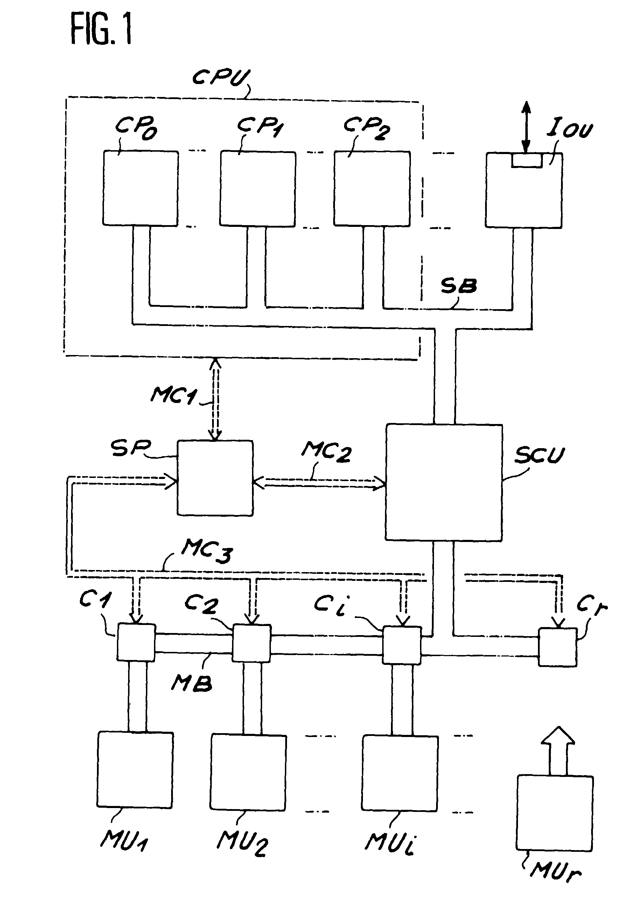

La figure 1 représente, à titre d'exemple non limitatif, un système informatique pouvant servir de cadre à l'invention. Le système décrit est un système multiprocesseur dont les moyens de traitement CPU sont formés par plusieurs processeurs élémentaires CP₀, ..., CP₁, ..., CP₂. Chacun de ces processeurs est relié à un bus système SB de façon à pouvoir communiquer avec les autres unités. Une ou plusieurs unités d'entrée-sortie IOU sont reliées également au bus système SB. Le système comprend d'autre part une mémoire constituée de plusieurs modules mémoire MU₁, MU₂, ..., MUᵢ, ..., MUᵣ reliés à un bus mémoire MB par des emplacements de connexion, respectivement C₁, C₂, ..., Cᵢ, ..., Cᵣ. Pour permettre les échanges d'information entre les processeurs élémentaires et les modules mémoires, le bus système SB est relié au bus mémoire MB par l'intermédiaire d'un contrôleur mémoire SCU. Le contrôleur mémoire SCU a pour fonctions d'une part de centraliser les demandes issues des processeurs élémentaires et d'autre part d'échanger des signaux de commande et de contrôle avec les modules mémoire pour effectuer les opérations de lecture et d'écriture sollicitées par les processeurs.

L'ensemble précédent qu'on appelle "sous-système central" est associé à un dispositif de maintenance comprenant essentiellement un processeur de service SP servant notamment à l'initialisation du système et aux opérations de maintenance. Le processeur de service comporte des moyens d'affichage et de commande permettant le dialogue avec un opérateur. Pour l'exécution de certaines opérations de maintenance, le processeur de service SP est relié aux diverses unités CPU, SCU, MUᵢ par des lignes de maintenance, respectivement MC₁, MC₂, MC₃. Ces lignes sont branchées à des circuits de maintenance (non représentés) contenus dans les unités. Ces circuits de maintenance sont conçus pour effectuer des diagnostics et exécuter dans les unités des opérations de maintenance commandées par le processeur de service. Le processeur de service peut en outre être relié au système de la même façon qu'un terminal. Ce mode de liaison (non représenté) permet de lancer des programmes de tests et en particulier des programmes de lecture et réécriture pour la mise en oeuvre des processus de recopie.

A ce niveau de description, le système selon l'invention ne se distingue physiquement d'un système classique que par l'existence de connecteurs supplémentaires Cᵣ, dont l'utilisation est réservée pour les opérations de remplacement de modules mémoire.

Le système qui vient d'être décrit possède un bus séparé MB affecté à la mémoire. Il convient toutefois de noter que l'invention pourrait également s'appliquer à un système muni d'un bus unique partagé par les processeurs, les unités d'entrée-sortie et les modules mémoire.

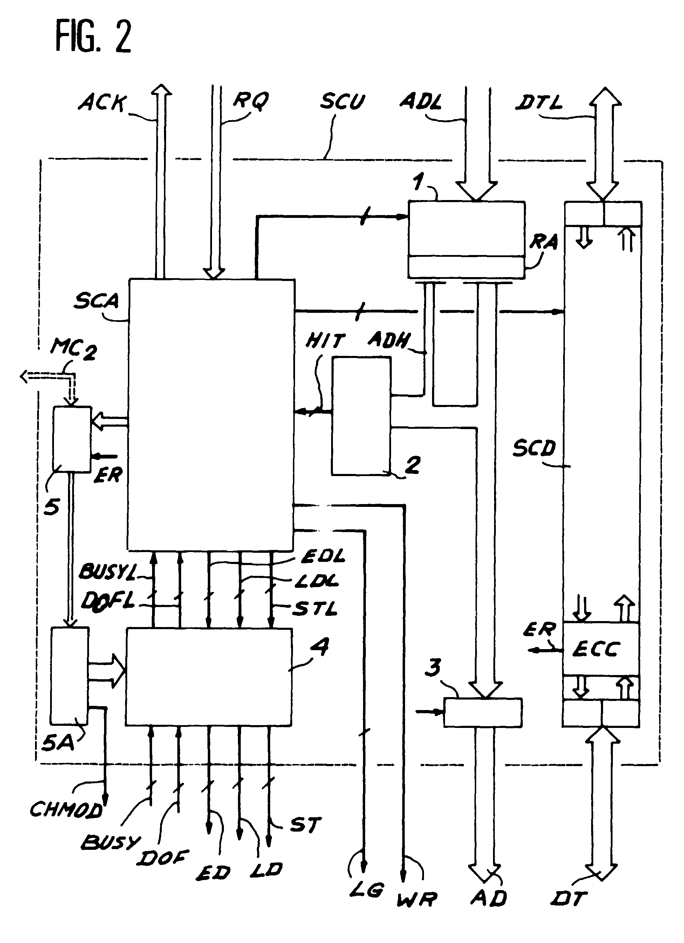

La figure 2 montre avec plus de détails le contrôleur mémoire SCU et ses liaisons avec d'une part le bus système SB et d'autre part le bus mémoire MB.

De façon classique, le contrôleur SCU échange avec les processeurs, par l'intermédiaire du bus système SB, des signaux de commande RQ et de réponse ACK, des signaux d'adresse ADL et les données DTL. D'autre part, le contrôleur SCU émet vers les modules mémoire des signaux de sélection ST, des signaux de commande ED, LD, WR, LG et les signaux d'adresse AD à l'intérieur des modules. Il reçoit des modules les signaux de contrôle BUSY, DOF et échange avec eux les données DT.

Selon un mode de réalisation particulier de l'invention, le contrôleur SCU émet également un signal de changement de mode CHMOD qui fera l'objet d'explications détaillées ultérieurement.

Il est à noter que l'invention peut très bien s'appliquer à des bus système de type quelconque comme par exemple un bus de type "message".

Dans l'exemple décrit, on peut classer les signaux échangés avec les modules mémoires en 2 catégories : ceux qui sont communs à tous les modules AD, DT, LG, WR, CHMOD et ceux qui ne concernent qu'un seul module ST, ED, LD, BUSY, DOF. Ces derniers sont véhiculés par autant de lignes qu'il y a de modules connectables sur le bus mémoire. Par exemple, les lignes de sélection ST sont constituées des lignes ST₁, ST₂, ..., STᵢ, ..., STᵣ reliées respectivement aux connecteurs C₁, C₂, ..., Cᵢ, ..., Cᵣ.

Pour la mise en oeuvre de l'invention, il est nécessaire que le contrôleur SCU puisse sélectionner pour une même demande plusieurs modules simultanément. Par contre, dans un système classique, le contrôleur ne peut sélectionner qu'un seul module à la fois. Pour des raisons de simplicité de réalisation, la solution proposée cherche à conserver la plupart des éléments constituant un contrôleur classique et à y adjoindre un circuit supplémentaire pour permettre des sélections simultanées.

Dans le contrôleur SCU, on distingue d'abord 3 principaux sous-ensembles classiques : un circuit de transmission de données SCD, des circuits 1, 2, 3 de traitement des adresses et un circuit de commande SCA. Le circuit supplémentaire évoqué ci-dessus est un circuit de conversion 4 des signaux échangés entre les modules et le circuit de commande SCA. A ces circuits fonctionnels s'ajoutent des circuits de maintenance 5, 5A reliés au processeur de service SP par les lignes de maintenance MC₂ constituées par exemple par une liaison série.

Avec ce choix de réalisation, pour chaque type de signaux non communs échangés entre le circuit de commande SCA et les modules (sélection, commande, contrôle), un seul signal parmi n, n étant le nombre de modules du système dans sa configuration normale, est actif à la fois. Dans un système classique, ces signaux sont directement échangés avec les modules. Par contre, selon l'invention, les signaux non communs issus du et reçus par le circuit de commande SCA doivent subir une conversion et seront donc qualifiés de signaux "logiques". Par analogie, nous définirons des modules "logiques" associés qui correspondraient aux modules réels ou "physiques" concernés par ces signaux dans le cas d'un système classique.

Ainsi le circuit de commande SCA émet les signaux de sélection logique STL, les signaux de commande logique EDL, LDL et reçoit les signaux de contrôle logique BUSYL, DOFL. A ces signaux logiques correspondent après conversion respectivement les signaux ST, ED, LD, BUSY, DOF effectivement échangés avec les modules physiques, signaux que l'on peut qualifier de signaux "physiques". Bien entendu les signaux communs WR, LG, ainsi que AD et DT échappent à cette distinction et lorsque le système est dans une configuration normale, le circuit de conversion 4 établit une simple correspondance biunivoque entre chaque signal logique et un signal physique unique.

Nous allons maintenant décrire plus en détail le contrôleur de la figure 2 ainsi que son fonctionnement.

Les demandes issues des processeurs se présentent sous la forme de signaux de commande RQ accompagnés de signaux d'adresse ADL et de données DTL dans le cas d'une écriture.

En réponse à ces demandes et en fonction de l'état du contrôleur, le circuit SCA fournit des signaux de réponse ACK. Le circuit de traitement des adresses est commandé par le circuit SCA et comporte un tampon d'entrée 1 relié aux lignes d'adresse ADL du bus SB et un tampon de sortie 3 relié aux lignes d'adresse AD du bus MB. Le tampon d'entrée 1 peut être composé de plusieurs registres, chaque registre étant dédié à un processeur ou à un contrôleur d'entrée-sortie du système. Le circuit de transmission des données SCD également commandé par le circuit SCA relie les lignes de données DTL du bus système SB aux lignes de données DT du bus mémoire MB par l'intermédiaire d'un circuit de détection et de correction d'erreurs ECC. Le circuit ECC, qui peut être de type classique, délivre des signaux de détection d'erreur ER. Les sorties du tampon d'entrée 1 sont reliées sélectivement à une table associative de configuration logique 2 servant à établir la correspondance entre les adresses reçues ADL et les modules logiques à sélectionner. La correspondance se matérialise par des signaux de coïncidence HIT transmis au circuit de commande SCA. En fonction des signaux de commande RQ et des signaux de coïncidence HIT, le circuit de commande SCA peut générer des signaux de sélection logique STL et de commande logique EDL, LDL servant à contrôler les modules mémoires. Le circuit SCA reçoit d'autre part des signaux de contrôle logiques BUSYL, DOFL représentatifs de l'état et des réponses des modules.

Le contrôleur SCU délivre d'autre part le signal WR dont la valeur logique indique s'il s'agit d'une lecture ou d'une écriture. Il délivre aussi le signal LG indicatif de la longueur du transfert. Ces signaux WR, LG sont issus du circuit de commande SCA et appliqués sans conversion aux modules.

Le contrôleur SCU comporte un circuit d'interface de maintenance 5 servant d'une part à mémoriser et transmettre les commandes issues du processeur de service et d'autre part à mémoriser et transmettre sous la commande du processeur de service des comptes rendus d'erreurs concernant le contrôleur. En particulier, le circuit 5 commande le circuit de maintenace 5A pour le positionnement du circuit de conversion 4 et la génération du signal CHMOD déjà évoqué.

A l'exception du circuit de conversion 4, les éléments qui composent le contrôleur SCU sont de type classique dans la technique des contrôleurs mémoire. Il est donc inutile de décrire ces éléments en détail car leur réalisation est à la portée de l'homme du métier. Nous nous bornerons donc à décrire les fonctions essentielles du contrôleur en relation avec les principaux signaux échangés avec ce dernier de façon à mieux situer l'invention dans son contexte. Bien entendu le contrôleur décrit ici ne doit être considéré que comme un exemple et de nombreuses variantes de réalisation du contrôleur peuvent être envisagées sans pour cela sortir du cadre de l'invention.

Dans l'exemple considéré, le contrôleur SCU sert d'interface entre plusieurs processeurs et plusieurs modules mémoire. En plus du rôle de contrôleur mémoire proprement dit, le contrôleur SCU a donc également une fonction de centralisation des demandes issues des processeurs. Pour cela, les demandes en instance sont placées dans des files d'attente gérées par le circui SCA. On prévoit pour chaque module logique une file d'attente capable de mémoriser autant de demande que le système comporte de processeurs et d'unités d'entrée-sortie. En réponse aux demandes reçues et en fonction de la disponibilité des modules mémoire concernés, le circuit SCA déclenche l'exécution des opérations de lecture ou d'écriture au niveau des modules par l'envoi de signaux de sélection et de commande logiques accompagnés ou suivis d'informations d'adresses AD et de données DT. L'indisponibilité éventuelle du module destinataire de la demande est prise en compte par le circuit de commande SCA grâce à un signal d'occupation apparaissant sur l'une des lignes BUSYL. Dans ce cas, le circuit SCA maintient la demande en attente dans la mémoire tampon de la file d'attente associée au module jusqu'à la libération du module.

Si un module destinataire d'une demande en attente devient disponible, un des signaux BUSYL change d'état, par exemple en prenant la valeur 0 logique et la demande peut être exécutée. Parallèlement à la mise à jour de la file d'attente, le circuit SCA active alors un des signaux de sélection logique STL qui active à son tour un signal ST. Il place aussi l'adresse AD dans le registre de sortie 3. Les lignes LG sont placées à un profil logique représentatif de la longueur du transfert. Enfin selon que la demande est une lecture ou une écriture, le signal WR est positionné à la valeur 0 ou 1 logique. Les signaux précédents sont reçus par le module concerné qui est alors en condition pour exécuter la demande.

Dans le cas d'une lecture, la disponibilité des données lues dans le module est signalée au circuit de commande SCA par un des signaux DOF converti en signal logique DOFL. Lorsque le circuit SCA est prêt à recevoir les données, il provoque l'activation d'un des signaux ED reçu par le module de façon à l'autoriser à émettre les données. Les données sont ensuite chargées dans le tampon d'entrée du circuit SCD. Ces données sont alors transmises par l'intermédiaire du circuit ECC au tampon de sortie côté bus système. En cas d'erreur détectée, le circuit ECC valide le signal ER qui est pris en compte par le circuit 5.

Dans le cas d'une écriture, lorsque les données sont présentes dans le tampon de sortie du circuit SCD, le circuit de commande SCA active par un des signaux LDL un des signaux LD qui est transmis au module pour l'autoriser à prendre en compte les données DT présentes sur le bus mémoire.

Les explications qui précèdent concernent un accès mémoire normal.

Pour mettre en oeuvre l'invention, le circuit de conversion 4 est conçu pour permettre l'exécution simultanée des opérations d'écriture dans un module à remplacer et dans un module de remplacement. Par ailleurs, le circuit de conversion 4 doit comprendre ou être associé à des moyens qui n'autorisent que le module à remplacer à exécuter les opérations de lecture.

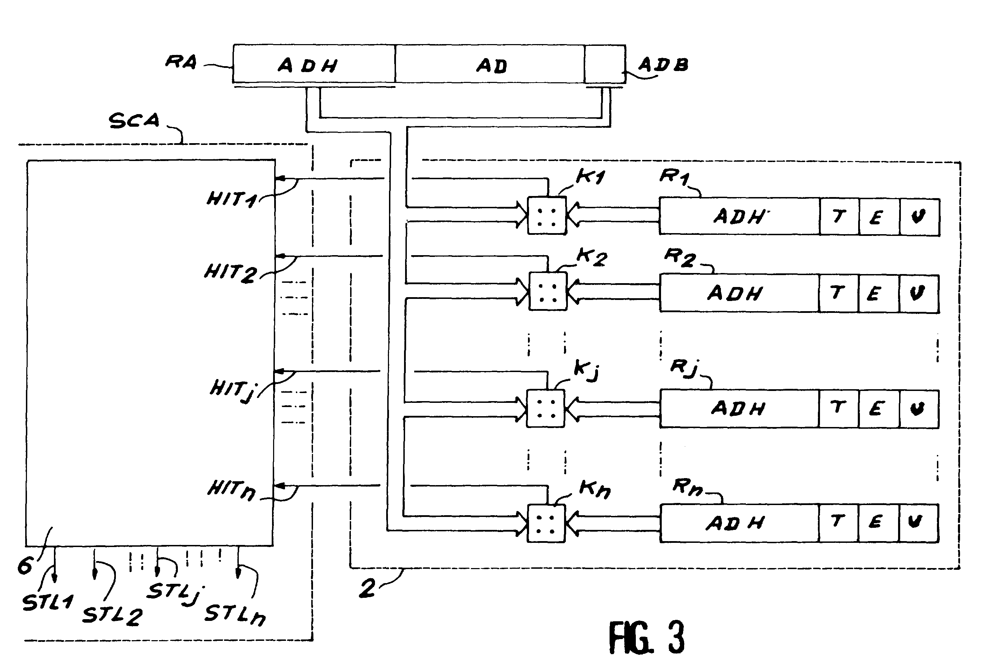

Une description détaillée du circuit 4 et des moyens associés sera donnée ultérieurement, mais avant cela il convient de se reporter à la figure 3 pour décrire les moyens permettant d'engendrer les signaux logiques qu'il reçoit.

La figure 3 représente une table associative de configuration logique 2 associée à un circuit de sélection logique 6 appartenant au circuit SCA. Pour exécuter une demande de lecture ou d'écriture, le contrôleur SCU place l'adresse associée ADL dans un registre d'adresses RA. L'adresse ADL peut être subdivisée en trois champs principaux : le champ ADH formé des poids forts de l'adresse, le champ ADB formé des poids faibles et le champ AD formé des bits restants. La table associative 2 comporte n registres de configuration logique R₁, R₂, ..., Rⱼ, ..., Rₙ, n étant le nombre de modules logiques, c'est-à-dire de modules qui composent la mémoire dans sa configuration normale. Chaque registre Rⱼ contient plusieurs champs d'informations ADH, T, E, V dont les valeurs sont spécifiques d'un module logique associé. Le premier champ ADH est affecté aux poids forts d'adresses attribués au module. Si les modules sont susceptibles d'avoir des tailles différentes, le champ T est affecté à la taille du module. Un champ E peut également être prévu pour contenir une information représentative du type d'entrelacement utilisé. Un dernier champ U est normalement prévu pour contenir un bit de validité du module logique.

Pour établir la correspondance entre une adresse reçue ADL et le module logique j concerné, le contenu de chaque registre est comparé aux poids forts ADH et aux poids faibles ADB de l'adresse. Ces comparaisons sont effectuées dans des comparateurs K₁, K₂, ..., Kⱼ, ..., Kₙ et normalement, pour une adresse logique donnée, un seul de ces circuits active un des signaux de coïncidence HIT₁, HIT₂, ..., HITⱼ, ..., HITₙ permettant d'identifier le module logique j affecté à l'adresse. En fonction des signaux de coïncidence HITⱼ, le circuit de sélection logique 6 peut activer un des signaux de sélection logique STL₁, STL₂, ..., STLⱼ, ..., STLₙ. En fonctionnement normal, un seul des signaux de sélection logique STLⱼ est actif, par exemple en prenant la valeur 1 logique. Bien entendu, ce signal de sélection logique n'est activé qu'à condition que le module logique concerné soit disponible.

Les signaux de coïncidence HITⱼ sont également utilisés par le circuit de commande SCA pour sélectionner lequel des signaux LDL ou EDL décrits précédemment doit être activé. Comme déjà dit précédemment, ces éléments font partie des techniques habituellement employées pour l'adressage des mémoires et une description plus détaillée sortirait du cadre de la présente invention.

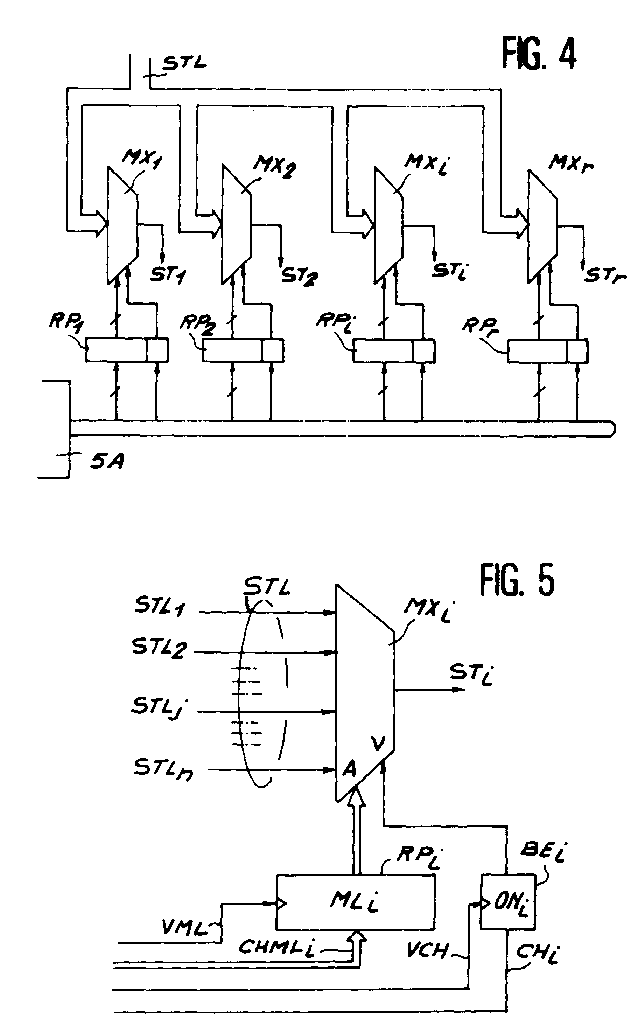

La figure 4 représente la partie du circuit de conversion 4 qui concerne les signaux de sélection ST, STL. Ce circuit comporte autant de multiplexeurs MX₁, MX₂, ..., MXᵢ, ..., MXᵣ que le bus mémoire possède d'emplacements de connexion. Chaque multiplexeur reçoit en entrée les signaux STL formés des signaux de sélection logique STL₁, ..., STLₙ. Ces multiplexeurs sont associés respectivement à des registres de configuration physique RP₁, RP₂, ..., RPᵢ, ..., RPᵣ. Chaque multiplexeur MXᵢ est commandé par la contenu de son registre de configuration physique associé RPᵢ. Chaque registre RPᵢ peut être chargé par le circuit de maintenance 5A en réponse aux ordres reçus du processeur de service. Les sorties des multiplexeurs délivrent les signaux de sélection physique ST₁, ST₂, ..., STᵢ, ..., STᵣ envoyés respectivement aux connecteurs C₁, C₂, ..., Cᵢ, ..., Cᵣ donc destinés respectivement aux modules physiques MU₁, MU₂, ..., MUᵢ, ..., MUᵣ.

Avant d'expliquer le fonctionnement du circuit de la figure 4, il convient de se reporter à la figure 5 qui représente de façon plus détaillée un des multiplexeurs MXᵢ et son registre de configuration physique associé RPᵢ affectés au module physique MUᵢ. Le multiplexeur MXᵢ comporte n entrées STL₁, STL₂, ..., STLⱼ, ..., STLₙ et une sortie STᵢ. En fonction des signaux d'adresse appliqués à l'entrée A du multiplexeur, la sortie STᵢ prend la valeur d'une des entrées STLⱼ lorsque le signal de validation appliqué à l'entrée de validation V est actif. Le registre de configuration physique RPᵢ contient le numéro de module logique MLᵢ associé au module physique MUᵢ. Le registre RPᵢ est associé à une bascule d'état BEᵢ dont la sortie est reliée à l'entrée de validation V du multiplexeur MXᵢ. La bascule BEᵢ contient l'indicateur d'état ONᵢ associé au module physique MUᵢ. Le circuit de maitenance 5A fournit au registre RPᵢ et à la bascule BEᵢ les signaux d'entrée, respectivement CHMLI et CHI, et les signaux de validation, respectivement VML et VCH.

Grâce à cette disposition, le processeur de service peut charger le registre RPᵢ avec un numéro de module logique MLᵢ quelconque. Ainsi, pour faire correspondre le module logique j au module physique MUᵢ, il suffit de forcer le contenu MLᵢ, du registre RPᵢ à la valeur j. Dans ce cas, l'activation du signal STLⱼ entrainera l'activation du signal STᵢ permettant la sélection du module physique MUᵢ.

La transformation des signaux logiques EDL et LDL en signaux physiques ED et LD pourra être réalisée au moyen de circuits identiques à celui de la figure 4. Bien entendu les registres RPᵢ et les bascule d'état BEᵢ pourront être communs aux trois circuits de conversion.

Pour effectuer, par exemple, la recopie du contenu du module MUᵢ associé initialement au module logique j dans le module de remplacement MUᵣ, on charge d'abord la valeur j dans le registre RPᵣ. Les registres RPᵢ et RPᵣ associés respectivement aux modules MUᵢ et MUᵣ contiennent donc tous deux la valeur j. Ainsi, toute demande d'écriture, adressée au module logique j sera physiquement adressée simultanément aux modules MUᵢ et MUᵣ. Nous verrons dans la suite de la description comment traiter le cas de la lecture.

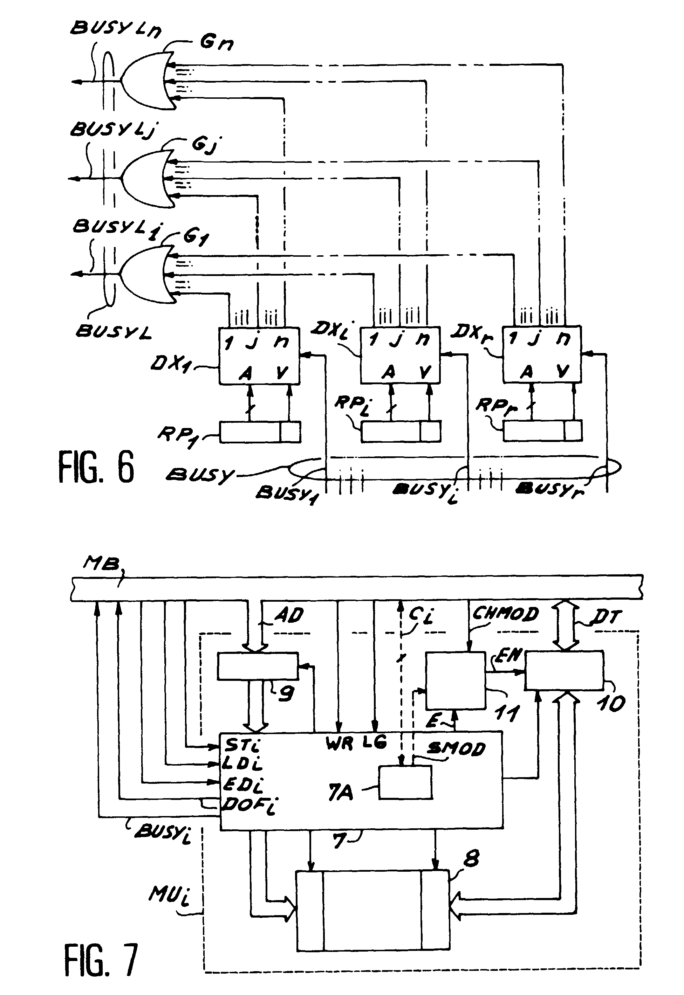

Le problème de la conversion des signaux de sélection et de commande ayant été résolu par le circuit de la figure 4, nous allons maintenant traiter un référence à la figure 6, le cas des signaux de contrôle, c'est-à-dire des signaux émis par les modules.

La figure 6 représente un mode de réalisation du circuit permettant la conversion des signaux d'occupation BUSYᵢ délivrés par les modules. Comme dans le circuit de la figure 4, on utilise les registres de configuration physique RPᵢ. Ces registres commandent commandent des démultiplexeurs DX₁, ..., DXᵢ, ..., DXᵣ adressés respectivement par les numéros de modules logiques contenus dans les registres associés. Chaque démultiplexeur DXᵢ est associé à un module physique MUᵢ et reçoit en entrée le signal d'occupation BUSYᵢ de ce module. Il délivre en sortie un signal parmi n sélectionné en fonction de l'adresse reçue sur son entrée d'adresse A. D'autre part, le circuit comprend des portes logiques G₁, ..., Gᵢ, ..., Gₙ reliées aux sorties des démultiplexeurs de la façon suivante : les entrées de même rang j des démultiplexeurs DX₁, ..., DXᵢ, ..., DXᵣ sont reliées à l'entrée d'une porte logique Gⱼ affectée à ce rang. Chaque porte logique Gⱼ fournit le signal d'occupation logique BUSYL. Si l'on convient que le signal d'occupation BUSYᵢ d'un module prend la valeur 1 logique lorsque ce module est occupé, les portes Gⱼ seront des portes OU. Ainsi, en cours de recopie, deux registres, par exemple RPᵢ et RPᵣ sont chargés avec le même numéro logique j. Les démultiplexeurs correspondants DXᵢ et DXᵣ transmettront les signaux d'occupation BUSYᵢ et BUSYᵣ de ces modules aux entrées de la même porte logique Gⱼ. Il en résulte que si l'un quelconque des modules MUᵢ ou MUᵣ est occupé, la sortie BUSYLⱼ de la porte Gⱼ prendra la valeur 1 logique, interdisant ainsi toute sélection du module logique j et donc des modules physiques MUᵢ et MUᵣ correspondants.

Un circuit analogue pourra être utilisé pour effectuer la conversion des signaux physiques DOF en signaux logiques DOFL.

Nous avons vu que la recopie du contenu d'un module MUᵢ dans un autre MUᵣ est réalisée en procédant à la lecture puis à la réécriture de tout l'espace mémoire couvert par le module logique j associé initialement au module physique MUᵢ. Au niveau des modules physiques, il faut que toute lecture concernant le module logique j en question ne soit exécutée que par le module à remplacer MUᵢ alors que toute écriture doit être exécutée à la fois dans le module à remplacer MUᵢ et dans le module de remplacement MUᵣ. Pour permettre ce fonctionnement, le module de remplacement doit être repéré en vue d'empêcher toute exécution de lecture de ce module. Dans ce but plusieurs solutions sont envisageables. On pourrait par exemple inhiber l'envoi de toute demande de lecture à destination du module de remplacement. Ceci pourrait être réalisé en forçant à zéro le signal de validation du multiplexeur concerné en fonction d'un indicateur signalant le statut de remplaçant du module physique associé lorsqu'une opération de lecture est exécutée (WR = 0). Pour mettre en oeuvre cette solution, il suffit d'associer à chaque registre de configuration physique RPᵢ une bascule de mode dont l'état logique indique si le module physique associé est un module "titulaire" ou un module de remplacement. Le signal de validation V du multiplexeur sera alors fonction de l'état logique de la bascule de mode, de l'état logique de la bascule d'état BEᵢ et du signal de lecture/écriture WR.

Cette solution peut toutefois poser des difficultés si l'on tient compte des considérations suivantes. Une fois la recopie terminée, il faut rétablir le système dans une nouvelle reconfiguration où le module de remplacement devient titulaire alors que le module à remplacer devient inactif. Ces changements de statuts sont initialisés par le processeur de service et exécutés par le circuit de maintenance 5 qui doit remettre à zéro l'indicateur d'état ONᵢ associé au module MUᵢ que l'on veut rendre inactif. D'autre part, l'état de la bascule de mode associée au module de remplacement doit être changé. Bien évidemment les changements d'état des bascules doivent être parfaitement synchrones pour éviter des perturbations si elles surviennent lors de l'exécution d'un accès mémoire. Cependant, malgré cette synchronisation, les changements d'état pendant l'exécution d'une opération de lecture peuvent poser des problèmes. En effet, une lecture s'exécute habituellement en plusieurs phases. Le module à remplacer risque alors d'être invalidé avant que ses données puissent être transmises alors que le module de remplacement n'a pas reçu et donc n'exécute aucune demande de lecture. Pour éviter ce problème, il faudrait donc prévoir un mécanisme de contrôle surveillant en permanence toutes les opérations de lecture en cours pour n'autoriser les changements d'état qu'en dehors des opérations de lecture.

Il est clair qu'un tel mécanisme entraîne une complication importante de la mise en oeuvre. C'est pourquoi selon un aspect particulier de l'invention, une solution différente a été adoptée. Selon cette solution, toute demande aussi bien de lecture que d'écriture est envoyée à la fois au module à remplacer et au module de remplacement. Toutefois, dans le cas d'une lecture, seul le module à remplacer est autorisé à envoyer effectivement les données accédées dans ce module. Il en résulte que des changements de statut peuvent se produire au cours d'une lecture sans entraîner des pertes d'informations.

La mise en oeuvre de cette solution va être expliquée en relation avec la figure 7 qui représente un des modules mémoire MUᵢ ainsi que les principaux signaux échangés avec le bus mémoire MB.

De façon connue en soi, le module MUᵢ comprend des circuits mémoire 8 constitués généralement d'une pluralité de composants. Le circuit mémoire 8 est associé à un contrôleur 7 qui lui fournit les adresses et les signaux de contrôle nécessaire à l'exécution des opérations de lecture ou d'écriture. Les données DT sont reçues par le circuit mémoire 8 après codage par le circuit de détection et de correction d'erreurs ECC. Le contrôleur 7 échange avec le bus MB les signaux STᵢ, LDᵢ, EDᵢ, DOFᵢ, BUSYᵢ WR, LG déjà définis précédemment. Il reçoit d'autre part des signaux d'adresse AD par l'intermédiaire d'un tampon d'entrée 9. Le circuit mémoire 8 est relié au bus MB par l'intermédiaire d'un circuit d'interface 10 constitué essentiellement de tampons d'entrée et de sortie et d'amplificateurs associés. Le contrôleur 7 comprend également un circuit de maintenance 7A relié par les lignes de maintenance Cᵢ au processeur de service SP pour effectuer les opérations de maintenance.

Selon une caractéristique particulière de l'invention, le module MUᵢ est muni d'un circuit d'inhibition 11 commandant par un signal EN l'amplificateur de sortie de l'interface 10 en fonction d'un signal E issu du contrôleur 7, du signal CHMOD provenant du contrôleur SCU et du signal SMOD issu du circuit de maintenance 7A.

En fonctionnement normal, , le module MUᵢ répond aux demandes de lecture et d'écriture reçues. Par contre, si le module MUᵢ est un module de remplacement, ce statut est signalé au circuit de maintenance 7A par le processeur de service. Le circuit de maintenance 7A active alors le signal de positionnement en mode remplaçant SMOD qui place le circuit d'inhibition 11 en condition pour bloquer toute émission de données par le circuit d'interface 10.

Pour rétablir le module MUᵢ dans son fonctionnement normal, le statut du module MUᵢ est modifié par l'envoi du signal de changement de mode CHMOD par le contrôleur SCU. En réponse au signal CHMOD, le circuit d'inhibition est replacé en condition pour autoriser les émissions de données.

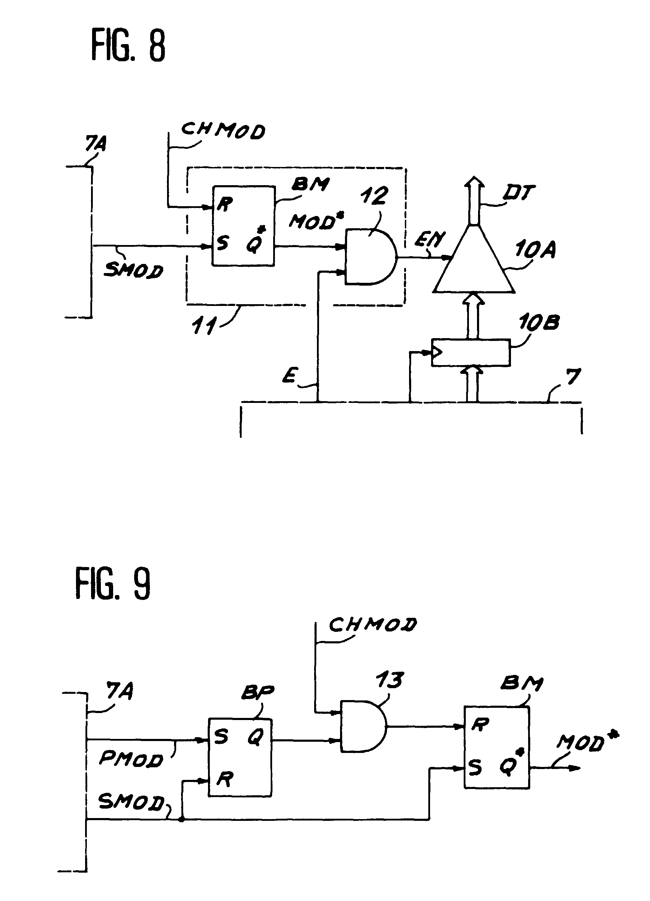

La figure 8 représente de façon plus détaillée le circuit d'inhibition 11 en relation avec l'amplificateur de sortie 10A de l'interface 10. En lecture, les données issues du circuit de détection et de correction d'erreurs ECC sont chargées dans le tampon de sortie 10B avant d'être transmises sur les lignes de données DT du bus MB par l'amplificateur de sortie 10A. Dans un module mémoire classique, le contrôleur 7 du module commande l'amplificateur de sortie 10A par un signal E de commande d'émission. Lorsque le module n'émet pas, le signal E prend une première valeur logique qui place l'amplificateur 10A à l'état de haute impédance E. Pour une valeur complémentaire de ce signal, l'amplificateur 10A est mis à l'état actif et les données contenues dans le tampon 10B sont reçues par les lignes de données DT du bus mémoire MB.

Selon l'invention, le signal de commande d'émission E n'est plus appliqué directement à l'entrée de validation de l'amplificateur 10 mais par l'intermédiaire du circuit d'inhibition 11. Le circuit 11 comprend une bascule de mode BM et une porte logique 12 dont la sortie EN est reliée à l'entrée de validation de l'amplificateur 10A. D'autre part, l'entrée de positionnement S de la bascule BM reçoit le signal SMOD issu du circuit 7A. L'entrée de remise à zéro R de la bascule BM reçoit le signal CHMOD. On a supposé que l'amplificateur 10A est à l'état de haute impédance lorsque son entrée de validation reçoit la valeur zéro logique. D'autre part, on convient que lorsque la bascule de mode BM est à l'état 1 logique, le module associé a le statut de remplaçant. La sortie inverseuse Q* de la bascule BM est alors reliée à l'entrée de la porte ET 12 dont la seconde entrée reçoit le signal E de commande d'émission issue du contrôleur 7.

Le circuit de la figure 8 fonctionne de la façon suivante : lorsqu'un module de remplacement a été connecté sur le bus MB, le processeur de service force le signal SMOD à la valeur 1 logique. La bascule BM prend donc l'état MOD = 1 et le signal complémentaire MOD* est appliqué à l'entrée de la porte 12. Il en résulte que la sortie de cette porte est à zéro, ce qui maintient l'amplificateur 10A à l'état de haute impédance interdisant ainsi l'envoi de toute donnée lue dans le module. Pour modifier le statut du module, le circuit de maintenance 5A du contrôleur SCU place le signal CHMOD à la valeur 1 logique ce qui remet à zéro la bascule BM. L'amplificateur 10A est alors commandé normalement par le signal E du contrôleur 7.

Si on se contente de la possibilité de remplacer un seul module à la fois, il y aura au plus un module ayant le statut de remplaçant. Le changement de statut pourra alors être effectué au moyen d'un signal unique CHMOD commun à tous les modules. Si par contre on veut se réserver la possibilité d'effectuer plusieurs remplacements à la fois, on devra prévoir la possibilité d'envoyer de façon sélective un signal de changement de mode CHMOD spécifique pour chaque module. Cette solution peut être mise en oeuvre grâce au circuit de la figure 8 à condition de prévoir des lignes de changement de mode en nombre égal au nombre de connecteurs du bus mémoire ainsi que des moyens de sélection de ces lignes.

La figure 9 représente une variante de réalisation du circuit d'inhibition 11 permettant le remplacement simultané de plusieurs modules tout en ne nécessitant qu'une seule ligne de changement de mode CHMOD. On retrouve sur la figure 9 la bascule de mode BM dont l'entrée de positionnement R reçoit le signal de sortie d'une porte ET 13 dont une première entrée reçoit le signal de changement de mode CHMOD et dont une seconde entrée est reliée à la sortie non inverseuse Q d'une bascule de prépositionnement BP. L'entrée de positionnement S de la bascule BP reçoit du processeur de service un signal de prépositionnement PMOD tandis que son entrée de remise à zéro R reçoit le signal SMOD. L'entrée de positionnement S de la bascule de mode BM reçoit, comme à la figure 8, le signal SMOD.

Le fonctionnement du circuit de la figure 9 est le suivant. Pour remettre a 0 la bascule du mode BM d'un module de remplacement déterminé, le processeur de service place d'abord à 1 la bascule de prépositionnement BP par le signal PMOD. Il en résulte que la porte ET 13 autorise la transmission du signal CHMOD. Lorsque le changement de statut est déclenché dans le circuit de maintenance 5, le signal CHMOD est mis comme précédemment à la valeur 1 logique, ce qui remet à 0 la bascule de mode BM. Ainsi, le changement de statut du module considéré est bien effectué à l'exclusion des autres modules de remplacement dans lesquels la bascule de prépositionnement BP est toujours à 0, ce qui interdit la prise en compte du signal de changement de mode.

Nous allons maintenant décrire une procédure complète de remplacement d'un module en nous plaçant d'abord dans le cas simplifié où on ne prévoit que le remplacement d'un seul module à la fois.

Normalement, le remplacement d'un module MUᵢ est suscité par la détection d'une erreur de lecture ER par le circuit de détection et de correction d'erreurs ECC du contrôleur SCU. Cette erreur est signalée au processeur de service en même temps que l'adresse correspondante. En fonction de ces informations, le processeur de service peut déterminer le numéro de module logique associé au module physique défectueux. Par ailleurs, le défaut est signalé à l'opérateur par la console de maintenance du processeur de service.

Lorsque l'opérateur veut effectuer le remplacement, il place sur le connecteur disponible un module neuf de remplacement MUᵣ. Il est à noter que cette opération est normalement précédée d'une procédure préparatoire permettant d'effectuer cette connexion sans perturber le fonctionnement du système. Pour cela, on peut par exemple procéder conformément aux enseignements de la demande de brevet français n° 88 16194 déposée le 9 décembre 1988 au nom de la demanderesse et ayant pour titre "Système électronique à plusieurs unités amovibles". Le contenu de la demande précitée doit être considéré comme faisant partie de la présente description.

L'opérateur ordonne ensuite au processeur de service d'effectuer la recopie. Le processeur de service active alors les opérations suivantes :
- par l'intermédiaire du circuit de maintenance 7A, mise à 1 de la bascule de mode BM du module de remplacement MUᵣ par le signal SMOD (figure 8) ;
- par l'intermédiaire du circuit de maintenance 5A, chargement du registre de configuration physique RPᵣ du module MUᵣ avec le même numéro de module logique que celui associé au module défaillant et mise à un de la bascule d'état BEᵣ associée (figure 5) ;
- passage de paramètres aux moyens de traitements CPU pour indiquer l'espace mémoire concerné et déclenchement du programmme ou du microprogramme de recopie dans l'un des processeurs (figure 1) ;
- prise en compte de la fin du processus de recopie signalée par les moyens de traitement ;
- par l'intermédiaire du circuit de maintenance 5A, mise à 0 de la bascule d'état BEᵢ associée au module à remplacer et simultanément mise à 1 du signal de changement de mode CHMOD (figures 2, 5, 7, 8) ;
- indication par la console de maintenance que la recopie est terminée et que la carte défaillante peut être retirée.

L'opérateur peut ensuite retirer la carte défaillante après avoir placé le système en condition pour le faire sans inconvénient.

Dans le cas où on voudrait pouvoir remplacer simultanément plusieurs modules, on applique une procédure analogue à la précédente, à la différence près que le processeur de service devra au préalable être informé par l'opérateur de l'identité des modules physiques manipulés. D'autre part, le changement d'état de la bascule de mode BM du module de remplacement doit être précédé par le positionnement de la bascule de prépositionnement BP (figure 9).

## Revendications

1. Procédé pour effectuer le remplacement d'un ou de plusieurs modules mémoire (MUᵢ) d'un système informatique, lesdits modules (MUᵢ) communiquant avec des moyens de traitement (CPU) dudit système par l'intermédiaire d'un bus (MB), ledit bus (MB) étant muni d'emplacements de connexion (Cᵢ) sur lesquels sont branchés lesdits modules (MUᵢ), ledit procédé étant caractérisé en ce qu'il consiste :
a) à prévoir, outre les emplacements de connexion (Cᵢ) nécessaires au système dans sa configuration normale, au moins un emplacement de connexion supplémentaire (Cᵣ),
b) lorsqu'un module à remplacer est identifié, à connecter un module de remplacement (MUᵣ) sur un desdits emplacements de connexion supplémentaire (Cᵣ),
c) pour toute demande d'écriture adressée audit module à remplacer (MUᵢ), à faire exécuter ladite demande d'écriture simultanément et à la même adresse par ledit module à remplacer (MUᵢ) et par son module de remplacement (MUᵣ) et, pour toute demande de lecture adressée audit module à remplacer (MUᵢ), à n'autoriser que ledit module à remplacer (MUᵢ) à exécuter ladite demande de lecture,
d) à lancer un processus de recopie composé de demandes de lecture puis de réécriture à un ensemble d'adresses recouvrant la totalité de l'espace mémoire du module à remplacer,
e) une fois ledit processus de recopie terminé, pour toute demande ultérieure adressée audit module à remplacer (MUᵢ), à n'autoriser que ledit module de remplacement (MUᵣ) à exécuter, à la même adresse, ladite demande ultérieure.

2. Procédé selon la revendication 1, caractérisé en ce que ledit processus de recopie est exécutable en parallèle avec d'autres programmes en cours d'exécution dans le système.

3. Procédé selon l'une des revendications 1 ou 2, caractérisé en ce que, pour n'autoriser que le module à remplacer (MUᵢ) à exécuter les demandes de lecture, toute demande de lecture est envoyé à la fois au module à remplacer (MUᵢ) et au module de remplacement (MUᵣ), ces deux modules accédant normalement aux données à lire et en ce que l'envoi par le module de remplacement (MUᵣ) des données accédées est inhibé.

4. Procédé selon la revendication 3, caractérisé en ce que tout module de remplacement (MUᵣ) est marqué par un indicateur de mode (MOD) signalant le statut de remplaçant dudit module et en ce que ladite inhibition est conditionnée par la présence dudit indicateur de mode (MOD).

5. Procédé selon la revendication 4, caractérisé en ce que, ledit système comportant n modules dans sa configuration normale, toute demande active, en fonction de l'adresse associée, un signal parmi n, appelé "signal de sélection logique" (STLⱼ) et en ce que, chaque module effectivement connecté au bus (MB) pouvant être commandé par un signal de sélection appelé "signal de sélection physique" (STᵢ), pour pouvoir sélectionner simultanément deux modules (MUᵢ, MUᵣ) en réponse à une demande déterminée, ledit signal de sélection logique (STLⱼ) associé à ladite demande déterminée active simultanément deux signaux de sélection physique (STᵢ, STᵣ) appliqués respectivement auxdits deux modules (MUᵢ, MUᵣ).

6. Procédé selon la revendication 5, caractérisé en ce que, tout signal de sélection physique (STᵢ) étant transmis à un module (MUᵢ) par l'intermédiaire d'un emplacement de connexion (Cᵢ), chaque emplacement de connexion (Cᵢ) est associé à un indicateur d'état (ONᵢ) et en ce qu'un signal de sélection physique (STᵢ) n'est envoyé à un module (MUᵢ) que si l'indicateur d'état (ONᵢ) associé à l'emplacement de connexion (Cᵢ) sur lequel est placé ledit module (MUᵢ) a une valeur logique déterminée.

7. Procédé selon la revendication 6, caractérisé en ce que, pour n'autoriser que le module de remplacement (MUᵣ) à exécuter les demandes une fois le processus de recopie terminé, on modifie les valeurs logiques respectivement de l'indicateur d'état (ONᵢ) associé au module à remplacer (MUᵢ) et l'indicateur de mode (MOD) associé au module de remplacement.

8. Procédé selon l'une des revendications 1 à 7, caractérisé en ce que, les modules mémoire (MUᵢ) étant associés à des moyens de détection et de correction d'erreurs (ECC), le remplacement d'un module (MUᵢ) est effectué avant que les erreurs détectées dans ledit module (MUᵢ) ne soient plus corrigeables.

9. Système informatique comprenant des moyens de traitement (CPU) reliés à plusieurs modules mémoire (MUᵢ) par l'intermédiaire d'un bus (MB), ledit bus (MB) étant muni d'emplacements de connexion (Cᵢ) sur lesquels sont branchés lesdits modules (MUᵢ), ledit système comprenant des moyens de commande (SCU, 11) pour sélectionner lesdits modules (MUᵢ) en réponse aux adresses associées aux demandes d'accès mémoire issues desdits moyens de traitement (CPU), un dispositif de maintenance (SP) étant en outre relié audit système, ledit système étant caractérisé en ce que :
a) outre les emplacements de connexion (Cᵢ) nécessaires au système dans sa configuration normale, au moins un emplacement de connexion supplémentaire (Cᵣ) est prévu pour y recevoir des modules de remplacement (MUᵣ),
b) pour pouvoir effectuer le remplacement d'un module (MUᵢ) par un autre (MUᵣ), lesdits moyens de commande (SCU, 11) peuvent être positionnés par le dispositif de maintenance (SP) de façon à ce que :
- toute demande d'écriture adressée à un module à remplacer (MUᵢ) est exécutée à la fois et à la même adresse par ledit module à remplacer (MUᵢ) et un module de remplacement associé (MUᵣ) et
- toute demande de lecture adressée audit module à remplacer (MUᵢ) n'est exécutée que par ledit module à remplacer (MUᵢ),
c) ledit système comprend des moyens pour exécuter, sous la commande dudit dispositif de maintenance (SP) un processus de recopie composé de demandes de lecture puis de réécriture à un ensemble d'adresses recouvrant la totalité de l'espace mémoire du module à remplacer (MUᵢ).

10. Système informatique selon la revendication 9, caractérisé en ce que lesdits moyens pour exécuter ledit processus de recopie consistent en un programme ou un microprogramme chargé dans lesdits moyens de traitement (CPU) et en ce que ledit programme ou microprogramme est exécutable en parallèle avec d'autres programmes en cours d'exécution dans lesdits moyens de traitement (CPU).

11. Système informatique selon l'une des revendications 9 ou 10, caractérisé en ce que lesdits moyens de commande (SCU, 11) comportent un circuit de sélection (SCA, 4) pour engendrer des signaux de sélection physique (STᵢ) des modules (MUᵢ) en fonction des adresses associées aux demandes, en ce que ledit circuit de sélection (SCA, 4) peut être positionné par le dispositif de maintenance (SP) de façon à ce que, pour un ensemble d'adresses correspondant à un module déterminé (MUᵢ), en réponse à toute adresse dudit ensemble, ledit circuit de sélection (SCA, 4) engendre à la fois un signal de sélection physique (STᵢ) dudit module déterminé (MUᵢ) et un signal de sélection physique (STᵣ) d'un autre module (MUᵣ) et en ce que lesdits moyens de commande (SCU, 11) comportent des moyens d'inhibition (11) pouvant être positionnés par le dispositif de maintenance (SP) de façon à interdire à au moins un module quelconque (MUᵣ) d'effectuer l'envoi des données lues dans ledit module quelconque (MUᵣ).

12. Système informatique selon la revendication 11, caractérisé en ce que lesdits moyens d'inhibition (11) sont constitués par des circuits d'inhibition (11) associés respectivement aux modules mémoire (MUᵢ), en ce que le circuit d'inhibition (11) d'un module comprend une bascule (BM), appelée "bascule de mode" qui, pour un premier état logique déterminé, commande l'inhibition de l'envoi des données lues dans ledit module (MUᵢ) et en ce que ladite bascule de mode (BM) d'un module quelconque peut être placé dans ledit premier état logique par le dispositif de maintenance (SP).

13. Système informatique selon la revendication 12, caractérisé en ce que, ledit système comportant n modules (MUᵢ) dans sa configuration normale, ledit circuit de sélection (SCA, 4) comprend un circuit de sélection logique (SCA) qui, en fonction de l'adresse associée à toute demande, engendre un signal parmi n appelé "signal de sélection logique" (STLⱼ) et en ce que ledit circuit de sélection (SCA, 4) comprend un circuit de conversion (4) qui, en réponse à un signal de sélection logique (STLⱼ) et selon le positionnement imposé par le dispositif de maintenance (SP), engendre un ou plusieurs signaux de sélection physique (STᵢ, STᵣ) destinés respectivement à un ou plusieurs modules (MUᵢ, MUᵣ).

14. Système informatique selon la revendication 13, caractérisé en ce que, tout signal de sélection physique (STᵢ) étant transmis à un module (MUᵢ) par l'intermédiaire d'un emplacement de connexion (Cᵢ), chaque emplacement de connexion (Cᵢ) est associé à une bascule d'état (ONᵢ) dont l'état logique est positionné par le dispositif de maintenance (SP) et en ce qu'un signal de sélection physique (STᵢ) n'est envoyé à un module (MUᵢ) que si la bascule d'état (ONᵢ) associée à l'emplacement de connexion (Cᵢ) sur lequel est placé ledit module (MUᵢ) est dans un premier état logique déterminé.

15. Système informatique selon la revendication 14, caractérisé en ce que lesdits moyens de commande (SCU) comportent un circuit de changement de mode (5) qui engendre un signal de changement de mode (CHMOD) lorsque l'une des bascules d'état (ONᵢ) est placée dans un deuxième état logique déterminé et en ce que ledit signal de changement de mode (CHMOD) est appliqué audit circuit d'inhibition (11) de chaque module (MUᵢ), ledit circuit d'inhibition (11) plaçant alors sa bascule de mode (BM) dans un deuxième état logique.

## Patentansprüche

1. Verfahren zum Ausführen des Austausches eines oder mehrerer Speichermodule (MUᵢ) eines Datenverarbeitungssystems, wobei die Module (MUᵢ) mit Verarbeitungsmitteln (CPU) des Systems über einen Bus (MB) kommunizieren, wobei der Bus (MB) mit Anschlußstellen (Cᵢ) versehen ist, an die die Module (MUᵢ) angeschlossen werden, wobei das Verfahren dadurch gekennzeichnet ist, daß es darin besteht:
a) außer den Anschlußstellen (Cᵢ), die für das System in dessen normaler Konfiguration notwendig sind, wenigstens eine zusätzliche Anschlußstelle (Cᵣ) vorzusehen,
b) an eine der zusätzlichen Anschlußstellen (Cᵣ) ein Austauschmodul (MUᵣ) anzuschließen, wenn ein auszutauschendes Modul identifiziert worden ist,
c) für jede Schreibanforderung, die an das auszutauschende Modul (MUᵢ) gerichtet ist, Ausführen der Schreibanforderung gleichzeitig und bei derselben Adresse durch das auszutauschende Modul (MUᵢ) und dessen Austauschmodul (MUᵣ) und für jede Leseanforderung, die an das auszutauschende Modul (MUᵢ) gerichtet ist, nur für das auszutauschende Modul (MUᵢ) die Ausführung der Leseanforderung zuzulassen,
d) einen Kopierprozeß zu beginnen, der aus Anforderungen zum Lesen und dann zum Wiedereinschreiben in einer Gesamtheit von Adressen, welche den gesamten Speicherraum des auszutauschenden Moduls abdecken,besteht
e) nach Beendigung des Kopierprozesses für jede spätere Anforderung, die an das auszutauschende Modul (MUᵢ) gerichtet ist, , nur für das Austauschmodul (MUᵣ) zuzulassen, daß es die spätere Anforderung bei der gleichen Adresse ausführt.

2. Verfahren nach Anspruch 1, dadurch gekennzeichnet, daß der Kopierprozeß parallel mit anderen im System momentan ausgeführten Programmen ausführbar ist.

3. Verfahren nach einem der Ansprüche 1 oder 2, dadurch gekennzeichnet, daß, damit die Ausführung der Leseanforderungen nur für das auszutauschende Modul (Muᵢ) zugelassen wird, jede Leseanforderung zugleich an das auszutauschende Modul (MUᵢ) und an das Austauschmodul (MUᵣ) geschickt wird, wobei diese beiden Module normalerweise auf die zu lesenden Daten zugreifen, und daß das Schicken durch das Austauschmodul (MUᵣ) von Daten, auf die zugegriffen wird, gesperrt wird.

4. Verfahren nach Anspruch 3, dadurch gekennzeichnet, daß jedes Austauschmodul (MUᵣ) durch einen Modusanzeiger (MOD) markiert ist, der den Austauschstatus des Moduls meldet, und daß die Sperrung durch das Vorhandensein des Modusanzeigers (MOD) konditioniert ist.

5. Verfahren nach Anspruch 4, dadurch gekennzeichnet, daß dann, wenn das System in seiner normalen Konfiguration n Module enthält, jede Anforderung in Abhängigkeit von der zugeordneten Adresse eines von n Signalen, das "logisches Wählsignal" (STLⱼ) genannt wird, aktiviert und daß, wenn jedes an den Bus (MB) tatsächlich angeschlossene Modul durch ein Wählsignal, das "physisches Wählsignal" (STᵢ) genannt wird, gesteuert wird, um als eine Antwort auf eine bestimmte Anforderung gleichzeitig die beiden Module (MUᵢ, MUᵣ) wählen zu können, das logische Wählsignal (STLⱼ), das der bestimmten Anforderung zugeordnet ist, gleichzeitig zwei physische Wählsignale (STᵢ, STᵣ), die an ein entsprechendes der beiden Module (MUᵢ, MUᵣ) angelegt werden, aktiviert.

6. Verfahren nach Anspruch 5, dadurch gekennzeichnet, daß dann, wenn jedes physische Wählsignal (STᵢ) über eine Anschlußstelle (Cᵢ) an ein Modul (MUᵢ) übertragen wird, jeder Anschlußstelle (Cᵢ) ein Zustandsanzeiger (ONᵢ) zugeordnet ist, und daß ein physisches Wählsignal (STᵢ) nur an ein Modul (MUᵢ) geschickt wird, wenn der Zustandsanzeiger (ONᵢ), der der Anschlußstelle (Cᵢ) zugeordnet ist, an der sich das Modul (MUᵢ) befindet, einen bestimmten logischen Wert besitzt.

7. Verfahren nach Anspruch 6, dadurch gekennzeichnet, daß, damit die Ausführung der Anforderungen nur für das Austauschmodul (Muᵣ) zugelassen wird, sobald der Kopierprozeß beendet ist, die logischen Werte des dem auszutauschenden Modul (MUᵢ) zugeordneten Zustandsanzeigers (ONᵢ) bzw. des dem Austauschmodul zugeordneten Modusanzeigers (MOD) modifiziert werden.

8. Verfahren nach einem der Ansprüche 1 bis 7, dadurch gekennzeichnet, daß dann, wenn den Speichermodulen (MUᵢ) Erfassungs- und Fehlerkorrekturmittel (ECC) zugeordnet sind, der Austausch eines Moduls (MUᵢ) erfolgt, bevor die erfaßten Fehler im Modul (MUᵢ) nicht mehr korrigierbar sind.

9. Datenverarbeitungssystem mit Verarbeitungsmitteln (CPU), die über einen Bus (MB) mit mehreren Speichermodulen (MUᵢ) verbunden sind, wobei der Bus (MB) mit Anschlußstellen (Cᵢ) versehen ist, an die die Module (MUᵢ) angeschlossen sind, wobei das System Steuermittel (SCU, 11) enthält, um die Module (MUᵢ) als Antwort auf Adressen, die den von den Verarbeitungsmitteln (CPU) ausgegebenen Speicherzugriffsanforderungen zugeordnet sind, zu wählen, wobei außerdem mit dem System eine Wartungsvorrichtung (SP) verbunden ist, wobei das System dadurch gekennzeichnet ist, daß:
a) außer den Anschlußstellen (Cᵢ), die für das System in seiner normalen Konfiguration notwendig sind, wenigstens eine zusätzliche Anschlußstelle (Cᵣ) vorgesehen ist, um hier Austauschmodule (MUᵣ) aufzunehmen,
b) um den Austausch eines Moduls (MUᵢ) durch ein anderes (MUᵣ) vornehmen zu können, die Steuermittel (SCU, 11) von der Wartungsvorrichtung (SP) in der Weise einge stellt werden können, daß:
- jede Schreibanforderung, die an ein auszutauschendes Modul (MUᵢ) gerichtet ist, zugleich und bei derselben Adresse durch das auszutauschende Modul (MUᵢ) und ein zugeordnetes Austauschmodul (MUᵣ) aus geführt wird und
- jede Leseanforderung, die an das auszutauschende Modul (MUᵢ) gerichtet ist, nur durch das auszutauschende Modul (MUᵢ) ausgeführt wird,
c) das System Mittel enthält, um unter der Steuerung der Wartungsvorrichtung (SP) einen Kopierprozeß auszuführen, der aus Anforderungen zum Lesen, und dann zum Wiedereinschreiben in einer Gesamtheit von Adressen, welche den gesamten Speicherraum des auszutauschenden Moduls (MUᵢ) abdecken, besteht.

10. Datenverarbeitungssystem nach Anspruch 9, dadurch gekennzeichnet, daß die Mittel zum Ausführen des Kopierprozesses aus einem Programm oder aus einem Mikroprogramm bestehen, das in die Verarbeitungsmittel (CPU) geladen ist, und daß das Programm oder das Mikroprogramm parallel mit anderen momentan in den Verarbeitungsmitteln (CPU) ausgeführten Programmen ausführbar ist.

11. Datenverarbeitungssystem nach einem der Ansprüche 9 oder 10, dadurch gekennzeichnet, daß die Steuermittel (SCU, 11) eine Wählschaltung (SCA, 4) enthalten, um physische Wählsignale (STᵢ) für die Module (MUᵢ) in Abhängigkeit von den den Anforderungen zugeordneten Adressen zu erzeugen, daß die Wählschaltung (SCA, 4) durch die Wartungsvorrichtung (SP) in der Weise positioniert werden kann, daß für eine Gesamtheit von Adressen, die einem bestimmten Modul (MUᵢ) entspricht, als Antwort auf jede Adresse der Gesamtheit die Wählschaltung (SCA, 4) zugleich ein physisches Wählsignal (STᵢ) des bestimmten Moduls (MUᵢ) und ein physisches Wählsignal (STᵣ) eines weiteren Moduls (MUᵣ) erzeugt, und daß die Steuermittel (SCU, 11) Sperrmittel (11) enthalten, die durch die Wartungsvorrichtung (SP) in der Weise eingestellt werden können, daß sie wenigstens einem beliebigen Modul (MUᵣ) verbieten, das Schicken der in diesem beliebigen Modul (MUᵣ) gelesenen Daten auszuführen.

12. Datenverarbeitungssystem nach Anspruch 11, dadurch gekennzeichnet, daß die Sperrmittel (11) aus Sperrschaltungen (11), die den Speichermodulen (MUᵢ) entsprechend zugeordnet sind, gebildet sind, daß die Sperrschaltung (11) eines Moduls eine Kippschaltung (BM) enthält, die "Moduskippschaltung" genannt wird und für einen bestimmten ersten logischen Zustand die Sperrung des Schickens der in diesem Modul (MUᵢ) gelesenen Daten steuert, und daß die Moduskippschaltung (BM) eines beliebigen Moduls durch die Wartungsvorrichtung (SP) in den ersten logischen Zustand versetzt werden kann.

13. Datenverarbeitungssystem nach Anspruch 12, dadurch gekennzeichnet, daß dann, wenn das System in seiner normalen Konfiguration n Module (MUᵢ) enthält, die Wählschaltung (SCA, 4) eine logische Wählschaltung (SCA) enthält, die in Abhängigkeit von der jeder Anforderung zugeordneten Adresse ein Signal aus n Signalen erzeugt, das "logisches Wählsignal" (STLⱼ) genannt wird, und daß die Wählschaltung (SCA, 4) eine Umsetzungsschaltung (4) enthält, die als Antwort auf ein logisches Wählsignal (STLⱼ) und gemäß der durch die Wartungsvorrichtung (SP) erzwungenen Einstellung ein oder mehr physische Wählsignale (STᵢ, STᵣ) erzeugt, die für eines bzw. mehrere Module (MUᵢ, MUᵣ) bestimmt sind.

14. Datenverarbeitungssystem nach Anspruch 13, dadurch gekennzeichnet, daß dann, wenn jedes physische Wählsignal (STᵢ) über eine Anschlußstelle (Cᵢ) an ein Modul (MUᵢ) übertragen wird, jeder Anschlußstelle (Cᵢ) eine Zustandskippschaltung (ONᵢ) zugeordnet ist, deren logischer Zustand durch die Wartungsvorrichtung (SP) eingestellt wird, und daß ein physisches Wählsignal (STᵢ) an ein Modul (MUᵢ) nur dann geschickt wird, wenn die Zustandskippschaltung (ONᵢ), die der Anschlußstelle (Cᵢ) zugeordnet ist, an der sich das Modul (MUᵢ) befindet, in einem bestimmten ersten logischen Zustand ist.

15. Datenverarbeitungssystem nach Anspruch 14, dadurch gekennzeichnet, daß die Steuermittel (SCU) eine Modusänderungsschaltung (5) enthalten, die ein Modusänderungssignal (CHMOD) erzeugt, wenn eine der Zustandskippschaltungen (ONᵢ) in einen zweiten bestimmten logischen Zustand versetzt ist, und daß das Modusänderungssignal (CHMOD) an die Sperrschaltung (11) jedes Moduls (MUᵢ) angelegt wird, wobei die Sperrschaltung (11) dann dessen Moduskippschaltung (BM) in einen zweiten logischen Zustand versetzt.

## Claims

1. Method for carrying out the replacement of one or more memory modules (MUᵢ) of a computer system, said modules (MUᵢ) communicating with processing means (CPU) of said system via a bus (MB), said bus (MB) being provided with connection locations (Cᵢ) to which said modules (MUᵢ) are connected, said method being characterised in that it consists:
a) in providing, apart from the connection locations (Cᵢ) necessary to the system in its normal configuration, at least one additional connection location (Cᵣ),
b) when a module to be replaced is identified, in connecting a replacement module (MUᵣ) to one of said additional connection locations (Cᵣ),
c) for any write request addressed to said module to be replaced (MUᵢ), in causing said write request to be executed simultaneously and at the same address by said module to be replaced (MUᵢ) and by its replacement module (MUᵣ) and, for any read request addressed to said module to be replaced (MUᵢ), in authorising only said module to be replaced (MUᵢ) to execute said read request,
d) in launching a copy-over process composed of read and then rewrite requests to a set of addresses covering all the memory space of the module to be replaced,
e) once said copy-over process is completed, for any subsequent request addressed to said module to be replaced (MUᵢ), in authorising only said replacement module (MUᵢ) to execute, at the same address, said subsequent request.

2. Method according to Claim 1, characterised in that said copy-over process can be executed in parallel with other programs currently being executed in the system.

3. Method according to one of Claims 1 or 2, characterised in that, in order to authorise only the module to be replaced (MUᵢ) to execute read requests, any read request is sent both to the module to be replaced (MUᵢ) and to the replacement module (MUᵣ), these two modules normally accessing the data to be read and in that the replacement module (MUᵢ) is inhibited from sending accessed data.

4. Method according to Claim 3, characterised in that any replacement module (MUᵣ) is marked by a mode indicator (MOD) indicating the status as a replacement of said module and in that said inhibition is dependent on the presence of said mode indicator (MOD).

5. Method according to Claim 4, characterised in that, said system comprising n modules in its normal configuration, any request activates, depending on the associated address, a signal from among n, called a "logical selection signal" (STLⱼ) and in that, each module actually connected to the bus (MB) being able to be controlled by a selection signal called a "physical selection signal" (STᵢ), in order to select simultaneously two modules (MUᵢ, MUᵣ) in response to a given request, said logical selection signal (STLⱼ) associated with said given request activates simultaneously two physical selection signals (STᵢ, STᵣ) applied to said two modules (MUᵢ, MUᵣ) respectively.

6. Method according to Claim 5, characterised in that, any physical selection signal (STᵢ) being transmitted to a module (MUᵢ) via a connection location (Cᵢ), each connection location (Cᵢ) is associated with a status indicator (ONᵢ) and in that a physical selection signal (STᵢ) is sent to a module (MUᵢ) only if the status indicator (ONᵢ) associated with the connection location (Cᵢ) on which said module (MUᵢ) is placed has a given logical value.

7. Method according to Claim 6, characterised in that, in order to authorise only the replacement module (MUᵣ) to execute requests once the copy-over process is terminated, the logical values respectively of the status indicator (ONᵢ) associated with the module to be replaced (MUᵢ) and the mode indicator (MOD) associated with the replacement module are modified.

8. Method according to one of Claims 1 to 7, characterised in that, the memory modules (MUᵢ) being associated with error detection and correction means (ECC), the replacement of a module (MUᵢ) is carried out before the errors detected in said module (MUᵢ) are no longer correctable.

9. Computer system comprising processing means (CPU) connected to several memory modules (MUᵢ) via a bus (MB), said bus (MB) being provided with connection locations (Cᵢ) to which said modules (MUᵢ) are connected, said system comprising control means (SCU, 11) for selecting said modules (MUᵢ) in response to the addresses associated with the memory access requests coming from said processing means (CPU), a maintenance device (SP) also being connected to said system, said system being characterised in that:
a) apart from the connection locations (Cᵢ) necessary to the system in its normal configuration, at least one additional connection location (Cᵣ) is provided so as to receive replacement modules (MUᵣ) there,
b) in order to be able to carry out the replacement of one module (MUᵢ) by another (MUᵣ), said control means (SCU, 11) can be positioned by the maintenance device (SP) so that:
- any write request addressed to a module to be replaced (MUᵢ) is executed at the same time and at the same address by said module to be replaced (MUᵢ) and by an associated replacement module (MUᵣ), and
- any read request addressed to said module to be replaced (MUᵢ) is executed only by said module to be replaced (MUᵢ),
c) said system comprises means for executing, under the control of said maintenance device (SP), a copy-over process composed of read requests and then rewrite requests to a set of addresses covering all the memory space of the module to be replaced (MUᵢ).

10. Computer system according to Claim 9, characterised in that said means for executing said copy-over process consist in a program or microprogram loaded into said processing means (CPU) and in that said program or microprogram can be executed in parallel with other programs currently being executed in said processing means (CPU).

11. Computer system according to one of Claims 9 or 10, characterised in that said control means (SCU, 11) comprise a selection circuit (SCA, 4) for generating physical selection signals (STᵢ) for the modules (MUᵢ) as a function of the addresses associated with the requests, in that said selection circuit (SCA, 4) can be positioned by the maintenance device (SP) so that, for a set of addresses corresponding to a given module (MUᵢ), in response to any address of said set, said selection circuit (SCA, 4) generates at the same time a physical selection signal (STᵢ) of said given module (MUᵢ) and a physical selection signal (STᵣ) of another module (MUᵣ) and in that said control means (SCU, 11) comprise inhibition means (11) that can be positioned by the maintenance device (SP) so as to prohibit at least one module (MUᵣ) of any kind from sending the data read to said module (MUᵣ) of any kind.

12. Computer system according to Claim 11, characterised in that said inhibition means (11) are constituted by inhibition circuits (11) associated respectively with the memory modules (MUᵢ), in that the inhibition circuit (11) of a module comprises a flip-flop (BM), known as a "mode flip-flop" which, for a first given logical state, controls the inhibition of the sending of the data read in said module (MUᵢ) and in that said mode flip-flop (BM) of any module can be placed in said first logic state by the maintenance device (SP).

13. Computer system according to Claim 12, characterised in that, since said system comprises n modules (MUᵢ) in its normal configuration, said selection circuit (SCA, 4) comprises a logical selection circuit (SCA) which, depending on the address associated with any demand, generates a signal from among n called a "logical selection signal" (STLⱼ) and in that said selection circuit (SCA, 4) comprises a conversion circuit (4) which, in response to a logical selection signal (STLⱼ) and according to the positioning imposed by the maintenance device (SP), generates one or more physical selection signals (STᵢ, STᵣ) intended respectively for one or more modules (MUᵢ, MUᵣ).

14. Computer system according to Claim 13, characterised in that, since any physical selection signal (STᵢ) is transmitted to a module (MUᵢ) via a connection location (Cᵢ), each connection location (Cᵢ) is associated with a state flip-flop (ONᵢ), the logical state of which is positioned by the maintenance device (SP), and in that a physical selection signal (STᵢ) is sent to a module (MUᵢ) only if the state flip-flop (ONᵢ) associated with the connection location (Cᵢ) on which said module (MUᵢ) is placed is in a given first logical state.

15. Computer system according to Claim 14, characterised in that said control means (SCU) comprise a mode-change circuit (5) that generates a mode-change signal (CHMOD) when one of the state flip-flops (ONᵢ) is placed in a given second logical state and in that said mode-change signal (CHMOD) is applied to said inhibition circuit (11) for each module (MUᵢ), said inhibition circuit (11) then placing its mode flip-flop (BM) in a second logic state.
